Europäisches Patentamt

European Patent Office

Office européen des brevets

(19)

(11) Veröffentlichungsnummer: **0 005 265**
**B1**

## (12) EUROPÄISCHE PATENTSCHRIFT

(45) Veröffentlichungstag der Patentschrift:
14.07.82

(21) Anmeldenummer: **79101335.2**

(22) Anmeldetag· **02.05.79**

(51) Int. Cl.³: **H 05 K 3/00,** H 05 K 3/30,
H 01 L 41/04

(54) Verfahren zur Kontaktierung der klebstoffseitigen Elektrode eines elektrischen Bauteiles.

(30) Priorität: **10.05.78 DE 2820403**

(43) Veröffentlichungstag der Anmeldung:
**14.11.79 Patentblatt 79/23**

(45) Bekanntmachung des Hinweises auf die Patenterteilung:
**14.07.82 Patentblatt 82/28**

(84) Benannte Vertragsstaaten:
**AT CH FR IT NL SE**

(56) Entgegenhaltungen:
**FR-A-2 140 651**
**US-A-2 877 363**

(73) Patentinhaber: **SIEMENS AKTIENGESELLSCHAFT**
**Berlin und München, Postfach 22 02 61,**
**D-8000 München 22 (DE)**

(72) Erfinder: **Schade, Reinhart, Mozartstrasse 11g,**
**D-8031 Olching (DE)**

## Verfahren zur Kontaktierung der klebstoffseitigen Elektrode eines elektrischen Bauteiles

Die Erfindung bezieht sich auf Verfahren zur Kontaktierung nach dem Oberbegriff der Patentansprüche 1 und 2.

Vielfach bestehen bestimmte elektrische Bauteile aus einem zu einem Formteil gestanzten Blech, welches als Träger eines elektrischen Bauelementes dient und mit diesem zu einer Baueinheit fest verbunden ist. Die Verbindung der beiden Teile erfolgt meist durch einen Zweikomponenten- oder Schmelzklebstoff.

Ist eine solche Trägerplatte beispielsweise mit einer scheibenförmigen Piezokeramik verbunden, wie man sie als Uhren-Summerscheibe oder Telefon-Piezowandler benötigt, so spricht man von einer sog. Verbundplatte.

Die Piezokeramik ist bei der Uhren-Summerscheibe bekanntlich beidseitig und ganzflächig mit Elektroden versehen. Die Elektroden können aus Einbrennsilber oder aus aufgedampften metallischen Schichten bestehen. Hierbei ergibt sich das Problem, daß die klebstoffseitige Elektrode nicht ohne weiteres mit der Trägerplatte kontaktiert werden kann. Es ist bekannt, die Trägerplatte selbst aus leitendem Material herzustellen und zur Verbindung der beiden Teile einen ausreichend niedrigviskosen Klebstoff zu verwenden. Die Schwierigkeit ergibt sich hierbei dadurch, daß zur Herstellung einer einwandfreien leitenden Verbindung zwischen Trägerplatte und klebstoffseitiger Elektrode ein ausreichend hoher Aufpreßdruck aufgewandt werden muß. Damit dieser Anpreßdruck einerseits nicht zu hoch gewählt werden muß und andererseits ein guter Kontakt gewährleistet ist, muß ein Klebstoff verwendet werden, der beim Aushärten ausreichend dünnflüssig ist. Außerdem muß die Oberfläche der Trägerplatte durch Aufrauhen und/oder zusätzlich eingeritzte Riefen mechanisch vorbehandelt werden. Dieses Verfahren ist relativ aufwendig und nicht automatisierungsfreundlich. Schon das Aushärten eines hierfür geeigneten Klebstoffes dauert bei 130°C 12 Stunden und ist daher bei einer Massenfertigung unrentabel.

Durch die US-PS 2 877 363 ist es bekannt, zur Kontaktierung von Piezowandlern als kontaktbildendes Mittel eine besonders gestaltete elektrische Zuleitung zu verwenden, die vor dem Fügevorgang auf die klebstoffbeschichtete Seite des Piezowandlers aufgelegt wird. Da die Dicke der elektrischen Zuleitung geringer ist als die Stärke der Klebstoffschicht, ist das mit dem Piezowandler in Kontakt tretende Ende der elektrischen Zuleitung wellenförmig ausgebildet, wobei die Amplitude dieser Wellen größer ist als die Dicke der Klebstoffschicht. Diese Ausbildung ist insbesondere dann von Vorteil, wenn zwei zu einem Paar zusammengefügte Piezowandler kontaktiert werden sollen.

Der Erfindung liegt die Aufgabe zugrunde, ein Verfahren zur Kontaktierung der klebstoffseitigen Elektrode eines elektrischen Bauteils zu schaffen, das nicht nur einfacher ist als die bekannten Verfahren, sondern auch universell einsetzbar und für eine Automatisierung geeignet ist. Diese Aufgabe wird gemäß der Erfindung dadurch gelöst, daß die Klebstoffschicht vor dem Fügevorgang auf die Trägerplatte aufgebracht wird und daß als kontaktbildende Mittel an der klebstoffbeschichteten Trägerplatte eingeprägte Erhöhungen verwendet sind, die höher als die Klebstoffschicht sind. Als kontaktbildende Mittel können auch elektrisch leitende Teile verwendet werden, die durch Stanzen hergestellt sind und deren Dicke einschließlich des Stanzgrads höher als die Klebstoffschicht ist, und die so auf die klebstoffbeschichtete Trägerplatte aufgelegt werden, daß der Stanzgrad des Stanzteiles von der Klebstoffschicht wegweist. Es ist besonders vorteilhaft als Klebemittel ein Copolymerisat zu verwenden. Dieses Klebemittel ist besonders geeignet für ein rationelles Kleben bei der Serienfertigung, da dieser Klebstoff nur eine relativ kurze Abbindezeit benötigt.

Anhand der Zeichnung wird das erfindungsgemäße Verfahren näher erläutert.

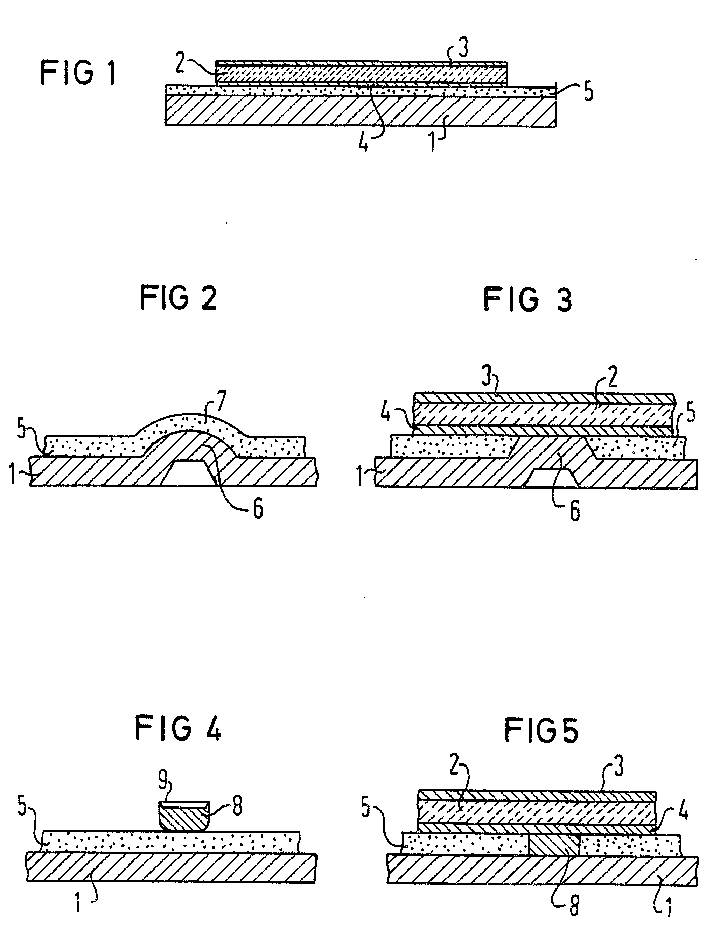

Fig. 1 dient lediglich zur Erläuterung des Standes der Technik, während die Fig. 2 bis 5 einige Anwendungsbeispiele zeigen.

Fig. 1 zeigt eine als Verbundplatte ausgebildete Uhren-Summerscheibe im Schnitt. Die Verbundplatte besteht aus einer Trägerplatte 1 aus elektrisch leitendem Material und einer scheiben- oder rechteckförmigen Piezokeramik 2, welche beidseitig und ganzflächig mit Elektroden 3 und 4 versehen ist. Die mit den Elektroden 3 und 4 versehene Piezokeramik 2 ist mit der Trägerplatte 1 durch Kleben fest verbunden. Mit 5 ist ein Klebstoff bezeichnet, der — z. B. in flüssiger Form — vor dem Fügevorgang auf die Trägerplatte 1 aufgebracht wird. Wird ein im Verhältnis zur Klebstoff-Viskosität ausreichend hoher Aufpreßdruck während des Aushärtens aufgewandt und ist die Oberfläche der Trägerplatte 1 aufgerauht, dann ist die klebstoffseitige Elektrode 4 mit der Trägerplatte 1 elektrisch leitend verbunden. Der Kontakt ist hier erwünscht und beabsichtigt, da die Uhren-Summerscheibe in einfacher Weise zwischen einem starren Uhrengehäuse und einem federnden Druckkontakt betrieben wird.

Verwendet man als Trägerplatte 1 ein für rationelles Kleben geeignetes, auf einer Seite mit einem Copolymerisat 5 beschichtetes Formteil, wie es Gegenstand der Anmeldung P 2 532 009.6-34 (VPA 75 P 7104 BRD) bildet, dann ist der elektrische Kontakt zwischen klebstoffseitiger Elektrode 4 und Trägerplatte 1 ohne besondere Maßnahmen — wegen der hohen Viskosität und Dicke des Klebstoffes 5 — nur mit verhältnismäßig großem Aufpreßdruck zu realisieren, was bei den meist dünnen Keramikscheiben 2 zu Bruch führen würde.

Beim Anwendungsbeispiel nach Fig. 1 zur Kontaktierung der klebstoffseitigen Elektrode 4 mit der Trägerplatte 1 ist man gezwungen, einen Klebstoff zu verwenden, der beim Aushärten ausreichend dünn ist. Um einen sicheren Kontakt zu erhalten, ist es außerdem erforderlich, durch Aufrauhen der Oberfläche die Trägerplatte 1 entsprechend vorzubehandeln. Dieses Verfahren ist sehr aufwendig und nicht automatisierungsfreundlich.

Anhand der Fig. 2 bis 5 wird nun das erfindungsgemäße Verfahren erläutert, das gegenüber den bekannten Verfahren den erheblichen Vorteil hat, daß als Klebstoff ein mit einem Copolymerisat beschichtetes Formteil verwendet werden kann.

Wie Fig. 2 zeigt, wird eine Trägerplatte 1 verwendet, die mit einer Copolymerisat-Schicht 5 versehen ist. Vor dem Heißkleben der Verbundplatte wird in die mit der Copolymerisat-Schicht 5 versehene Trägerplatte 1 eine oder mehrere Erhöhungen 6 geprägt, die im metallischen Teil ein wenig höher als die Klebstoffschicht 5 dick sein sollen, wie Fig. 2 zeigt.

Fig. 3 zeigt die kontaktierte Verbundplatte nach dem Heißverkleben. Die gemäß Fig. 2 noch auf der Erhöhung 6 befindliche Klebstoffkuppe 7 wird beim Aufpressen der mit den Elektroden 3 und 4 belegten Piezokeramik 2 auf die erwärmte Trägerplatte 1 seitlich und vollständig in die plastifizierte Klebstoffschicht 5 verdrängt. Da die geprägte Erhöhung 6 höher als die Klebstoffschicht dick ist, kommt ein sicherer elektrischer Kontakt zwischen klebstoffseitiger Elektrode 4 und Trägerplatte 1 zustande. Vorzugsweise ist der zum Aufpressen der Piezokeramik erforderliche Aufpreßstempel metallisch hart, so daß die eingeprägte Erhöhung 6 um einen geringen Betrag zurückgedrückt wird, wie Fig. 3 zeigt.

Fig. 4 und 5 zeigen ein anderes Ausführungsbeispiel, wobei Fig. 4 den Zustand vor dem Heißverkleben und Fig. 5 den Zustand nach dem Heißverkleben zeigen. Auch in diesem Falle kann wiederum eine mit einer Copolymerisat-Schicht 5 versehene Trägerplatte 1 verwendet werden, wobei vor dem Füge- und Klebvorgang auf die Klebstoffschicht 5 ein oder mehrere elektrisch leitende Stanzteile 8 aufzulegen sind, deren Stärke dicker als die Klebstoffschicht 5 ist. Das Stanzteil 8 ist vorzugsweise so auf die Klebstoffschicht 5 aufgelegt, daß sein Stanzgrat 9 von der Klebstoffschicht 5 wegweist. Beim Aufpressen der Piezokeramik 2 auf die erwärmte Trägerplatte 1 wird das Stanzteil 8 durch die Klebstoffschicht 5 gedrückt. Die typische Form des Stanzteiles 8 erleichtert das Eindringen in den plastifizierten Klebstoff 5 sowie das seitliche Verdrängen des Klebstoffes während des Fügevorganges. Wie Fig. 5 zeigt, wird nach dem Fügevorgang der Stanzgrat 9 teilweise zusammengedrückt und dringt teilweise in die Elektrode 4 ein, wodurch ein guter elektrischer Kontakt zwischen klebstoffseitiger Elektrode 4 und Trägerplatte 1 hergestellt ist. Das erfindungsgemäße Verfahren läßt also die Verwendung eines Copolymerisat als Klebstoff zu, der gegenüber den anderen bekannten Klebstoffen die Vorteile hat, daß eine geringere Temperatur und eine wesentlich kürzere Abbindezeit benötigt werden.

**Patentansprüche**

1. Verfahren zur Kontaktierung der klebstoffseitigen Elektrode eines mit einer elektrisch leitenden Trägerplatte mit Hilfe eines isolierenden Klebstoffes verbundenen elektrischen Bauteiles, wobei die Klebstoffschicht an einer oder mehreren Stellen durch kontaktbildende Mittel beim unter Wärme- und Druckeinwirkung stattfindenden Füge- und Klebevorgang verdrängt wird, dadurch gekennzeichnet, daß die Klebstoffschicht (5) vor dem Fügevorgang auf die Trägerplatte (1) aufgebracht wird und daß als kontaktbildendes Mittel an der klebstoffbeschichteten Trägerplatte (1) eingeprägte Erhöhungen (6) verwendet sind, die höher als die Klebstoffschicht (5) sind.

2. Verfahren zur Kontaktierung der klebstoffseitigen Elektrode eines mit einer elektrisch leitenden Trägerplatte mit Hilfe eines isolierenden Klebstoffes verbundenen elektrischen Bauteiles, wobei die Klebstoffschicht an einer oder mehreren Stellen durch kontaktbildende Mittel beim unter Wärme- und Druckeinwirkung stattfindenden Füge- und Klebevorgang verdrängt wird, dadurch gekennzeichnet, daß die Klebstoffschicht (5) vor dem Fügevorgang auf die Trägerplatte (1) aufgebracht wird und daß als kontaktbildende Mittel elektrisch leitende Teile (8) verwendet sind, die durch Stanzen hergestellt sind und deren Dicke einschließlich des Stanzgrads (9) höher als die Klebstoffschicht (5) ist, und die so auf die klebstoffbeschichtete Trägerplatte (1) aufgelegt werden, daß der Stanzgrad (9) des Stanzteiles (8) von der Klebstoffschicht (5) wegweist.

3. Verfahren nach Anspruch 1 oder 2, gekennzeichnet durch die Verwendung eines Copolymerisats als Klebemittel.

**Claims**

1. A process for contacting the electrode of an electrical component which is connected to an electrically-conductive carrier plate by means of an insulating adhesive, which electrode is arranged on the side of the component adjacent to the adhesive, wherein the layer of adhesive is removed at one or more places by contact-forming means during the joining and bonding step which is carried out under the influence of heat and pressure, characterised in that the adhesive layer (5) is applied to the carrier plate (1) prior to the joining step, and that projections (6) which are embossed on the adhesive-coated carrier plate (1) and which are higher than the adhesive layer (5) are used as the contact-forming means.

2. A process for contacting the electrode of an electrical component which is connected to an electrically-conductive carrier plate by means of an insulating adhesive, which electrode is arranged on the side of the component adjacent to the adhesive, wherein the layer of adhesive is removed at one or more places by contact-forming means during the joining and bondig step which is carried out under the influence of heat and pressure, characterised in that the adhesive layer (5) is applied to the carrier plate (1) prior to the joining step, and that electrically-conductive components (8) are used as contact-making means, which components are produced by punching and the thickness, including the punching ridge (9), is greater than that of the adhesive layer (5), and which are placed on the adhesive-coated carrier plate (1) in such manner that the punching ridge (9) of the punching member (8) faces away from the adhesive layer (5).

3. A process as claimed in Claim 1 or Claim 2, characterised by the use of a copolymer as the adhesive.

**Revendications**

1. Procédé pour établir le bonding de l'électrode, située du côté de l'adhésif, d'une pièce électrique détachée reliée au moyen d'un adhésif à une plaque de support électriquement conducteur, la couche d'adhésif étant refoulée en un ou en plusieurs endroits par des moyens susceptibles de former des contacts, lors d'une opération d'assemblage et de collage opérée avec mise en oeuvre de la chaleur et de la pression, caractérisé par le fait que la couche d'adhésif (5) est déposée sur la plaque de support (1) avant l'opération d'assemblage et que le moyen formant les contacts est constitué par des protubérances (6) obtenues par une opération de repoussage de la plaque de support (1) encollée et qui ont une hauteur supérieure à la couche d'adhésif (5).

2. Procédé pour établir le bondig de l'électrode, située du côté de l'adhésif, d'une pièce électrique détachée reliée au moyen d'un adhésif isolant à une plaque de support électriquement conductrice, la couche d'adhésif étant refoulée en un ou en plusieurs endroits par des moyens pour former des contacts lors d'une opération d'assemblage et de collage opérée avec mise en oeuvre de la chaleur et de la pression, caractérisé par le fait que la couche d'adhésif (5) est déposée sur la plaque de support (1) avant l'opération d'assemblage, et que les moyens servant à former des contacts sont constitués par des éléments (8) électriquement conducteurs, réalisés par estampage et dont les épaisseurs, y compris l'arête d'estampage (9) sont plus hautes que la couche d'adhésif (5), et qui sont placés de telle manière sur la plaque de support (1) revêtue d'adhésif que l'arête d'estampage (9) de la partie estampée (8) est éloignée de la couche d'adhésif.

3. Procédé selon la revendication 1 ou 2, caractérisé par la mise en oeuvre d'un copolymérisat comme adhésif.

FIG 1

FIG 2

FIG 3

FIG 4

FIG 5